# EUROPEAN PATENT APPLICATION

(11) **EP 2 703 526 A1**
(43) Date of publication of application: **05.03.2014**
(21) Application number: 13763892.0
(22) Date of filing: 22.01.2013
(51) Int. Cl.: C30B 29/06, C03B 20/00, C30B 15/10

(54) **A SILICA CONTAINER FOR PULLING UP MONOCRYSTALLINE SILICON AND METHOD FOR MANUFACTURING SAME**

(30) Priority: 23.03.2012 JP 2012067815
(71) Applicant: Shin-Etsu Quartz Products Co., Ltd., Shinjuku-ku Tokyo 160-0023 (JP)
(72) Inventor: YAMAGATA, Shigeru, Tokyo 160-0023 (JP)
(74) Representative: Wibbelmann, Jobst
(86) International application number: PCT/JP2013/000273
(87) International publication number: WO 2013/140706

(57) **Abstract**

The present invention is directed to a silica container for pulling single crystal silicon, the silica container including a straight body portion, a curved portion, and a bottom portion, wherein the outside of the silica container is made of opaque silica glass containing gaseous bubbles, the inside of the silica container is made of transparent silica glass containing substantially no gaseous bubble, and, on the inner surface of the bottom portion, a silica glass layer containing the OH group in a concentration of more than 300 ppm by mass but 3000 ppm by mass or less, the silica glass layer having a thickness of 20 µm or more but 1000 µm or less, is formed. As a result, a low-cost silica container for pulling single crystal silicon, the silica container that can reduce cavity defects called voids and pinholes in pulled single crystal silicon, is provided.

## Description

### TECHNICAL FIELD

The present invention relates to a silica container for pulling single crystal silicon and a method for producing the silica container.

### BACKGROUND ART

In the past, as a method for producing a silica crucible for producing single crystal silicon for LSIs (large-scale integrated circuits), the production methods described in Patent Literature 1 and Patent Literature 2 have been used. These methods are the methods by which, after quartz powder or synthetic cristobalite powder which was processed to be ultrapure is charged into a rotating mold and is molded, electrodes are pushed thereinto from above and voltage is applied to the electrodes to produce arc discharge, whereby the temperature of an atmosphere is raised to a melting temperature range (which is estimated to be about 1800 to 2100°C) of the quartz powder or the like to melt and sinter the quartz powder or the like. However, since ultrapure quartz raw material powder is used in these production methods, these production methods are high in cost. Moreover, problems related to the quality of single crystal silicon has arisen, such as silicon monoxide (SiO) gas that is generated as a result of the reaction between molten silicon and a silica crucible when the produced silica crucible is used and is then taken into single crystal silicon as gaseous bubbles (gas bubbles). In the following description, a silica crucible and a quartz crucible are synonymous with each other. Moreover, silica glass and quartz glass are also synonymous with each other.

Moreover, in Patent Literature 3, a silica crucible having a three-layer structure formed of an external layer made of natural quartz glass, an intermediate layer made of synthetic quartz glass containing a high concentration of aluminum, and an internal layer made of high-purity synthetic quartz glass based on an arc discharge melting method of silica powder raw materials (an atmosphere at the time of melting is estimated to be the air) is disclosed. In addition, the effect of preventing the movement of impurities (shielding effectiveness) by the intermediate layer is disclosed. However, in addition to the high cost of the three-layer structure, the problem of gaseous bubbles formed of SiO or the like, the gaseous bubbles contained in the produced single crystal silicon, is not solved.

Furthermore, in Patent Literature 4, a technique of reducing gaseous bubbles in a melted silica crucible wall by suction under a reduced pressure from the periphery of a molding die at the time of arc discharge melting of a silica powder raw material compact is disclosed. However, it is impossible to eliminate dissolved gas in the silica crucible wall completely only by sucking in the air present in a temporary compact of the silica powder under a reduced pressure. Moreover, there is a problem of SiO gas that is generated by the reaction between molten silicon and a silica crucible when the silica crucible is used and is taken into single crystal silicon as gaseous bubbles.

In addition, in Patent Literature 5, a quartz glass crucible for pulling single crystal silicon, the quartz glass crucible with a two-layer structure formed of an opaque external layer made of natural quartz powder and a transparent internal layer, the quartz glass crucible in which a transparent layer made of silica glass with 100 to 300 ppm OH group content is further formed on an inner surface layer from a bottom portion to a curved portion of the crucible, is disclosed. However, the object of this invention is to pull single crystal silicon more stably by suppressing the vibration of the surface of silicon melt when the crucible is used, and therefore this does not prevent the generation of cavity defects such as gaseous bubbles in single crystal silicon to be pulled upwardly.

Moreover, in Patent Literature 6, a quartz glass crucible that can prevent the generation of cavity defects called cavities (voids), non-through small-diameter holes (pinholes), and the like in a silicon wafer, the cavity defects caused as a result of SiO gas bubbles being taken into large-diameter single crystal silicon, is disclosed. As a way of preventing it, providing projections and depressions formed as many scratches having a depth of 50 to 450 µm in at least part of the inner surface of a straight body portion and a curved portion of a crucible is disclosed. However, with such an irregular surface, degassing of the generated SiO gas to the outside of a silica container is inadequate, and, in particular, when single crystal silicon has a large diameter of 12 inches (300 mm) or more, it is difficult to achieve a sufficient reduction of cavities (voids) and non-through small-diameter holes (pinholes) in a silicon wafer made by slicing and polishing such single crystal silicon.

Furthermore, also in Patent Literature 7, a quartz glass crucible that can prevent the generation of cavity defects caused as a result of SiO gas bubbles being taken into single crystal silicon is disclosed. As a way of preventing it, forming a region with high light transmittance in the bottom portion of a crucible is disclosed, whereby an increase in the temperature of the bottom portion is suppressed and it is possible to prevent the generation of SiO gas. However, inadequate suppression of the reaction between a quartz crucible and silicon melt is achieved by merely adjusting the light transmittance.

In addition, also in Patent Literature 8, an invention that can prevent the generation of cavity defects caused as a result of SiO gas bubbles being taken into single crystal silicon is disclosed. As a way of preventing it, setting a region with a high Al concentration in a inner surface layer portion of a bottom portion of a crucible is disclosed, whereby the viscosity of the bottom portion at a high temperature is increased and it is possible to prevent scratches and depressions reliably, the scratches and the depressions which are considered to be points of origin of gaseous bubbles. However, since the Al concentration is in the high concentration range of 30 to 150 ppm, there arises a problem of an Al element taken into the produced single crystal silicon.

Furthermore, also in Patent Literature 9, an invention that is considered to be capable of preventing the generation of cavity defects caused as a result of SiO gaseous bubbles being taken into single crystal silicon is disclosed. As a way of preventing it, forming the inside of a crucible bottom portion as a quartz glass layer with the OH group concentration of 100 ppm or less is described as a way that prevents the formation of depressions in the inner surface of a crucible bottom portion when a crucible is used and is capable of reducing the generation of SiO gas in the crucible bottom portion. However, the viscosity of the quartz glass layer with the OH group concentration of 100 ppm or less is high at a high temperature and makes it harder for depressions to be formed in the inner surface, but, once depressions are formed, it becomes difficult to remove them.

Moreover, in Patent Literature 10, a quartz glass crucible with a natural quartz glass layer as an external layer thereof and a synthetic quartz glass layer as an internal layer thereof, the quartz glass crucible in which only the inner surface of a crucible bottom portion is provided with a three-layer structure including a second natural quartz glass layer, is disclosed. The reason of such a structure is described as follows: Since the rate of dissolution of natural quartz glass in silicon melt is faster than that of synthetic quartz glass, minute depressions formed in the crucible bottom portion are dissolved and removed at an early point. However, since natural quartz glass contains various impurity metal elements in high concentrations, there arise a problem of contamination of ultrapure silicon melt.

### CITATION LIST

### PATENT LITERATURE

Patent Literature 1: Japanese Examined Patent Application Publication No. H4-22861
Patent Literature 2: Japanese Examined Patent Application Publication No. H7-29871
Patent Literature 3: Japanese Unexamined Patent Application Publication No. H9-255476
Patent Literature 4: Japanese Unexamined Patent Application Publication No. H10-25184
Patent Literature 5: WO 2004/097080
Patent Literature 6: Japanese Unexamined Patent Application Publication No. 2010-126423
Patent Literature 7: Japanese Unexamined Patent Application Publication No. 2010-155765
Patent Literature 8: Japanese Unexamined Patent Application Publication No. 2010-155760
Patent Literature 9: Japanese Unexamined Patent Application Publication No. 2010-138005
Patent Literature 10: Japanese Unexamined Patent Application Publication No. 2010-132534

### SUMMARY OF INVENTION

### TECHNICAL PROBLEM

The present invention has been made in view of the problems described above and an object thereof is to provide a low-cost silica container for pulling single crystal silicon, the silica container that can reduce cavity defects called voids and pinholes in pulled single crystal silicon, and a method for producing such a silica container.

### SOLUTION TO PROBLEM

The present invention has been made to solve the above-described problems and provides a silica container for pulling single crystal silicon, the silica container including a straight body portion, a curved portion, and a bottom portion, wherein, the outside of the silica container is made of opaque silica glass containing gaseous bubbles, the inside of the silica container is made of transparent silica glass containing substantially no gaseous bubble, and, on the inner surface of the bottom portion, a silica glass layer containing the OH group in a concentration of more than 300 ppm by mass but 3000 ppm by mass or less, the silica glass layer having a thickness of 20 µm or more but 1000 µm or less, is formed.

With a silica container in which a silica glass layer with such the OH group concentration (a silica glass layer with a high OH group concentration) is formed on the inner surface of the bottom portion, even when a large number of dents are formed in the bottom portion by filling of polysilicon raw material blocks which are heavy in weight, it becomes possible to melt and remove the dents at an early point by a subsequent reaction between silicon melt and the silica glass layer with a high OH group concentration. This makes it possible to maintain the inner surface of the bottom portion in a smooth surface state and thereby prevent the generation and growth of gaseous bubbles in the inner surface of the bottom portion caused by atmospheric gas such as argon (Ar) and gas, such as SiO, produced by the reaction when single crystal silicon is pulled upwardly. As a result, it is possible to reduce cavity defects called voids and pinholes in a single crystal silicon wafer produced from a pulled single crystal silicon ingot.

In this case, it is preferable that the silica glass layer formed on the inner surface of the bottom portion contains the OH group in a concentration of 500 ppm by mass or more but 1500 ppm by mass or less and has a thickness of 50 µm or more but 500 µm or less.

By providing the silica glass layer on the inner surface of the bottom portion with such the OH group concentration and a thickness, it is possible to promote the reaction between the silica glass layer with a high OH group concentration and the silicon melt and melt and remove the dents more effectively.

Moreover, it is preferable that the silica glass layer formed on the inner surface of the bottom portion is made of synthetic silica glass.

Furthermore, it is preferable that concentrations of impurities contained in the silica glass layer formed on the inner surface of the bottom portion are 100 ppb by mass or less for each of Li, Na, and K, 50 ppb by mass or less for each of Ca and Mg, and 20 ppb by mass or less for each of Ti, Cr, Fe, Ni, Cu, Zn, Zr, Mo, W, and Pb.

As described above, by using, as the silica glass layer on the inner surface of the bottom portion, a silica glass layer made of synthetic silica glass and setting the impurity concentrations of the silica glass layer on the inner surface of the bottom portion in the above-described ranges, it is possible to prevent impurity contamination of the silicon melt by the silica glass layer itself on the inner surface of the bottom portion.

Moreover, it is preferable that a region in which the silica glass layer formed on the inner surface of the bottom portion is formed has a diameter which is 1/3 or more of the outside diameter of the silica container.

By forming the silica glass layer on the inner surface of the bottom portion in such an area, it is possible to suppress the generation of gaseous bubbles in this area when single crystal silicon is pulled upwardly. This makes it possible to prevent more effectively the gaseous bubbles from being taken into single crystal silicon which is being pulled upwardly.

Furthermore, the present invention provides a method for producing a silica container for pulling single crystal silicon, the silica container including a straight body portion, a curved portion, and a bottom portion, the method including: a step of making silica powder having a particle size of 10 to 1000 µm as first raw material powder; a step of making silica powder having a particle size of 10 to 1000 µm and containing the OH group in a concentration of more than 300 ppm by mass but 3000 ppm by mass or less as second raw material powder; a step of obtaining a temporary compact made of the first raw material powder by charging the first raw material powder into a mold having rotational symmetry and temporarily molding the first raw material powder into a predetermined shape corresponding to the inner wall of the mold while rotating the mold; a step of making a silica container whose outside is made of opaque silica glass containing gaseous bubbles and inside is made of transparent silica glass containing substantially no gaseous bubble, the silica container including a straight body portion, a curved portion, and a bottom portion, by performing heating from the inside of the temporary compact made of the first raw material powder by a discharge heating melting method while rotating the mold; and a step of forming a silica glass layer in an inner surface portion of the bottom portion by melting the second raw material powder by the discharge heating melting method while spreading the second raw material powder into a space in the silica container thus made and making the melted second raw material powder adhere to the inner surface portion of the bottom portion.

With such a method, it is possible to form a silica glass layer with a high OH group concentration in the container bottom portion. With such a silica container produced in this manner, even when dents are formed in the container bottom portion, it is possible to melt and remove the dents at an early point by a subsequent reaction between silicon melt and the silica glass layer with a high OH group concentration. Moreover, this makes it possible to maintain the inner surface of the bottom portion in a smooth surface state and thereby prevent the generation and growth of gaseous bubbles in the inner surface of the bottom portion caused by atmospheric gas such as argon (Ar) and gas, such as SiO, produced by the reaction when single crystal silicon is pulled upwardly. As a result, it is possible to reduce cavity defects called voids and pinholes in a single crystal silicon wafer produced from a pulled single crystal silicon ingot.

In this case, heating of the temporary compact made of the first raw material powder may be performed concurrently with pressure reduction from the outside of the temporary compact made of the first raw material powder.

As described above, by performing heating of the temporary compact made of the first raw material powder while performing pressure reduction, it is possible to make efficiently a silica container whose outside is made of opaque silica glass containing gaseous bubbles and inside is made of transparent silica glass containing substantially no gaseous bubble.

Moreover, it is preferable that the second raw material powder is synthetic silica glass powder.

Furthermore, it is preferable that the impurity concentrations of the second raw material powder are set at 100 ppb by mass or less for each of Li, Na, and K, at 50 ppb by mass or less for each of Ca and Mg, and at 20 ppb by mass or less for each of Ti, Cr, Fe, Ni, Cu, Zn, Zr, Mo, W, and Pb.

As described above, by using synthetic silica glass powder as the second raw material powder and setting the impurity concentrations of the second raw material powder in the above-described ranges, it is possible to provide the silica glass layer formed on the inner surface of the container bottom portion with a low impurity concentration.

Moreover, it is preferable that a region in which the silica glass layer formed on the inner surface portion of the bottom portion is formed has a diameter which is 1/3 or more of the outside diameter of the silica container.

By forming the silica glass layer on the inner surface of the bottom portion in such an area, it is possible to suppress the generation of gaseous bubbles in this area in the produced silica container when single crystal silicon is pulled upwardly and prevent more effectively the gaseous bubbles from being taken into single crystal silicon which is being pulled upwardly.

### ADVANTAGEOUS EFFECTS OF INVENTION

A silica container for pulling single crystal silicon according to the present invention is a silica container in which a silica glass layer with a high OH group concentration is formed on the inner surface of a bottom portion. With such a silica container, even when a large number of dents are formed in the bottom portion by filling of polysilicon raw material blocks which are heavy in weight, it becomes possible to melt and remove the dents at an early point by a subsequent reaction between silicon melt and the silica glass layer with a high OH group concentration. This makes it possible to maintain the inner surface of the bottom portion in a smooth surface state and thereby prevent the generation and growth of gaseous bubbles in the inner surface of the bottom portion caused by atmospheric gas such as argon (Ar) and gas, such as SiO, produced by the reaction when single crystal silicon is pulled upwardly. As a result, it is possible to reduce cavity defects called voids and pinholes in a single crystal silicon wafer produced from a pulled single crystal silicon ingot. Moreover, with a method for producing a silica container for pulling single crystal silicon, the method according to the present invention, it is possible to produce such a silica container at low cost.

### BRIEF DESCRIPTION OF DRAWINGS

FIG. 1 is a schematic sectional view schematically depicting an example of the structure of a silica container according to the present invention;
FIG. 2 is a flow diagram of the outline of an example of a method for producing a silica container according to the present invention;
FIG. 3 is a schematic sectional view of an example of a mold that can be used in the method for producing a silica container according to the present invention;
FIG. 4 is a schematic sectional view of another example of the mold that can be used in the method for producing a silica container according to the present invention;
FIG. 5 is a schematic sectional view schematically depicting an example of a step of forming a temporary compact made of first raw material powder in the method for producing a silica container according to the present invention;
FIG. 6 is a schematic sectional view schematically depicting part (before discharge heating melting) of an example of a step of heating the temporary compact made of the first raw material powder in the method for producing a silica container according to the present invention;
FIG. 7 is a schematic sectional view schematically depicting part (during discharge heating melting) of the example of the step of heating the temporary compact made of the first raw material powder in the method for producing a silica container according to the present invention; and
FIG. 8 is a schematic sectional view schematically depicting a step of forming a silica glass layer in an inner surface portion of a bottom portion in the method for producing a silica container according to the present invention.

### DESCRIPTION OF EMBODIMENTS

In a silica container for pulling single crystal silicon for LSIs or solar cells (solar single crystal silicon), it is necessary to heat the inside of the container uniformly in a heating high-temperature atmosphere. To achieve this, a first challenge is to provide at least a straight body portion of the silica container with a two-layer structure, the outside thereof being made of porous opaque silica glass and the inside thereof being made of transparent silica glass containing substantially no gaseous bubble.

Moreover, as the diameter of single crystal silicon is increased and reaches a diameter of 12 inches (300 mm) or a diameter of 18 inches (450 mm), a silica container for pulling single crystal silicon grows in size and the weight of a polysilicon raw material with which the container is filled is increased. It is for this reason that gaseous bubbles contained in silicon melt remains in the melt and these gaseous bubbles are taken into single crystal silicon which is being produced, resulting in an increase in defects generated in a silicon wafer produced from this single crystal silicon, the defects called cavities (voids) and non-through small-diameter holes (pinholes). It is estimated that the cause of these defects is argon (Ar) or the like, which is filled as atmospheric gas at the time of production of single crystal silicon, argon (Ar) or the like that is adsorbed onto the inner surface of the silica container, and silicon monoxide (SiO) gas that is generated by the reaction between the silica container and silicon (Si) that is melted in the container. In particular, when polysilicon raw material blocks are charged into the silica container and heated, a large number of dents are made in the inner surface of a silica container bottom portion as a result of the weights of the silicon raw material blocks being added thereto. These dents become points of origin and growth spots of the above-described Ar gas or SiO gas bubbles. A second challenge of the present invention is to reduce cavity defects called voids and pinholes in the produced single crystal silicon by melting and removing the dents in the silica container bottom portion, the dents which become points of origin of gaseous bubbles, at an early point.

In the present invention, it is necessary to solve the above-described two technical challenges at the same cost as a crucible for pulling high-purity single crystal silicon or at lower cost than the crucible for pulling high-purity single crystal silicon, the crucible produced by an existing production method.

Furthermore, if impurity metal elements contained in the silica container, not only alkali metal elements Li, Na, and K, for example, but also alkaline earth metal elements Ca and Mg and transition metal elements Ti, Cr, Fe, Ni, Cu, Zn, Zr, Mo, W, Pb, and the like are taken into single crystal silicon at the time of production of the single crystal silicon, the photoelectric conversion efficiency is reduced in a solar silicon device, for example. Therefore, it is preferable to provide the silica container with a highly-pure inner surface to prevent the impurities contained in the silica container from diffusing to silicon melt.

Hereinafter, a silica container for pulling single crystal silicon according to the present invention and a method for producing the silica container will be described in detail with reference to the drawings, but the present invention is not limited thereto.

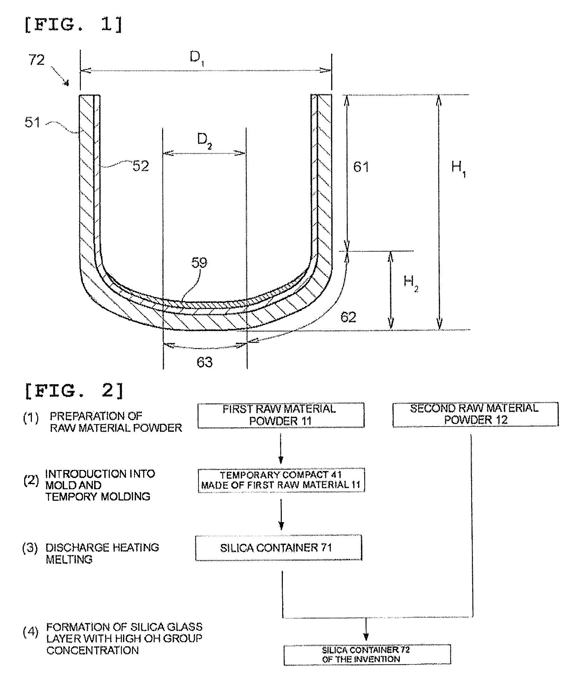

A silica container for pulling single crystal silicon according to the present invention will be described with reference to FIG. 1. As depicted in FIG. 1, a silica container 72 according to the present invention has the shape of a crucible having rotation axis symmetry and has a straight body portion 61, a curved portion 62, and a bottom portion 63. At this time, for the sake of convenience, 1/3 of the outside diameter (D₁) of the silica container 72 is assumed to be the diameter (D₂) of the bottom portion 63. The straight body portion 61 corresponds to a portion (height H₁-H₂) from an upper edge of the silica container 72 to a portion located at 1/3 of the height (H₁) thereof. Moreover, of a portion (height H₂) from the portion located at 1/3 of the height (H₁) of the silica container 72 to the bottom portion 63, a portion other than the bottom portion 63 is assumed to be the curved portion 62.

Moreover, the outside of the silica container 72 is made of opaque silica glass containing gaseous bubbles (an opaque silica glass layer 51) and the inside of the silica container 72 is made of transparent silica glass containing substantially no gaseous bubble (a transparent silica glass layer 52). Incidentally, the opaque silica glass layer 51 is usually white and opaque, and the transparent silica glass layer 52 is usually colorless and transparent. The bulk density of the opaque silica glass layer 51 is about 1.90 to 2.15 (g/cm³), and the bulk density of the transparent silica glass layer 52 located on the inside of the straight body portion 61 is approximately 2.20 (g/cm³). By providing the silica container 72 with such a two-layer structure, it is possible to heat the inside of the silica container 72 uniformly when the silica container is used at a high temperature.

In the silica container 72 of the present invention, on the inner surface of the bottom portion 63, a silica glass layer 59 with a high OH group concentration is formed. The silica glass layer 59 with a high OH group concentration contains the OH group in a concentration of more than 300 ppm by mass but 3000 ppm by mass or less, and the thickness thereof is 20 µm or more but 1000 µm or less.

By setting the OH group concentration of the silica glass layer 59 formed on the inner surface of the bottom portion 63 at more than 300 ppm by mass, the silica glass layer 59 is quickly melted and removed with the reaction between the silica glass layer 59 and silicon melt. That is, a large number of dents in the inner surface of the bottom portion 63, the dents formed as a result of the silica container 72 having been filled with polysilicon raw material blocks, are easily melted and removed at an early point by reaction with silicon melt obtained as a result of the polysilicon raw material blocks having been melted, which makes it easy to turn the inner surface of the bottom portion 63 into a smooth surface. This makes it possible to prevent the generation and growth of gaseous bubbles caused by atmospheric gas such as argon (Ar) and gas, such as SiO, produced by the reaction, the generation and growth of gaseous bubbles promoted by the dents in the inner surface of the silica container, when single crystal silicon is pulled upwardly. As a result, it is possible to reduce cavity defects called voids and pinholes in a single crystal silicon wafer produced from a pulled single crystal silicon ingot. It is preferable to set the OH group concentration of the silica glass layer 59 with a high OH group concentration at 500 ppm by mass or more.

On the other hand, by setting the OH group concentration of the silica glass layer 59 formed on the inner surface of the bottom portion 63 at 3000 ppm by mass or less, it is possible to prevent excessive melting of the inner surface of the bottom portion. The excessive melting of silica glass (SiO₂) of the inner surface of the bottom portion increases the concentration of oxygen (O) in the silicon melt or generates vapor (H₂O) and oxygen gas (O₂), resulting in a reduction in the quality of the pulled single crystal silicon. It is preferable to set the OH group concentration of the silica glass layer 59 with a high OH group concentration at 1500 ppm by mass or less.

Moreover, to obtain the above-described dent removing effect, it is necessary to set the thickness of the silica glass layer 59 with a high OH group concentration at 20 µm or more. It is preferable to set this thickness at 50 µm or more. If this thickness is less than 20 µm, the dents often penetrate the silica glass layer 59 with a high OH group concentration, and, even when the silica glass layer 59 with a high OH group concentration is melted and removed, the dents remain, whereby the effect cannot be obtained. Furthermore, by setting the thickness of the silica glass layer 59 with a high OH group concentration at 1000 µm or less, it is possible to perform quick melting and removal of the silica glass layer 59 with a high OH group concentration by reaction with the silicon melt. It is preferable to set this thickness at 500 µm or less.

Incidentally, it is technically difficult to perform actual measurement of the OH group concentration of the silica glass layer 59 with a high OH group concentration, the silica glass layer 59 having such a thickness (in particular, the actual measurement thereof becomes more difficult as the thickness becomes closer to 20 µm which is a lower limit). When actual measurement of this OH group concentration is difficult, it is possible to estimate this OH group concentration based on the concentration of the OH group contained in raw material powder, for example.

Moreover, it is preferable that the concentrations of impurities contained in the silica glass layer 59 with a high OH group concentration, the silica glass layer 59 formed on the inner surface of the bottom portion 63, are 100 ppb by mass or less for each of Li, Na, and K, 50 ppb by mass or less for each of Ca and Mg, and 20 ppb by mass or less for each of Ti, Cr, Fe, Ni, Cu, Zn, Zr, Mo, W, and Pb. Such impurity concentrations can be easily obtained by using the silica glass layer 59 with a high OH group concentration, the silica glass layer 59 made of synthetic silica glass.

It is preferable that a region in which the silica glass layer 59 with a high OH group concentration is formed has a diameter which is 1/3 or more of the outside diameter of the silica container 72. By forming the silica glass layer 59 with a high OH group concentration in such an area, it is possible to suppress the generation of gaseous bubbles in an entire area of the bottom portion 63 when single crystal silicon is pulled upwardly. This makes it possible to prevent more effectively the gaseous bubbles from being taken into single crystal silicon which is being pulled upwardly. When the silica glass layer 59 with a high OH group concentration, the silica glass layer 59 formed on the inner surface of the bottom portion 63 of the silica container 72, is formed only in a circular area of the bottom portion 63, it has the effect of preventing the generation of gaseous bubbles, but it is sometimes preferable to set the silica glass layer 59 in an area from the bottom portion 63 to the curved portion 62 or on the entire inner surface of the silica container. The area of the silica glass layer 59 with a high OH group concentration can be set depending on the pulling conditions of single crystal silicon.

As described above, in the silica container for pulling single crystal silicon, the silica container of the present invention, by adopting a two-layer structure in which the outside is an opaque silica glass layer having good thermal insulation and containing gaseous bubbles and the inside is a transparent silica glass layer containing substantially no gaseous bubble, the above-described first challenge can be overcome. Moreover, by forming, on the inner surface of the silica container bottom portion, a silica glass layer containing the OH group in a concentration of more than 300 ppm by mass but 3000 ppm by mass or less, the silica glass layer having a thickness of 20 µm or more but 1000 µm or less, even when a large number of dents are formed in the bottom portion by filling of polysilicon raw material blocks which are heavy in weight, it becomes possible to melt and remove the dents at an early point by a subsequent reaction between the silicon melt and the silica glass layer with a high OH group concentration. This makes it possible to maintain the inner surface of the bottom portion in a smooth surface state and thereby prevent the generation and growth of gaseous bubbles in the inner surface of the bottom portion caused by atmospheric gas such as argon (Ar) and gas, such as SiO, produced by the reaction when single crystal silicon is pulled upwardly. As a result, it is possible to reduce cavity defects called voids and pinholes in a single crystal silicon wafer produced from a pulled single crystal silicon ingot and overcome the above-described second challenge.

The purity of a portion of the silica container 72, the portion other than the silica glass layer 59 with a high OH group concentration (that is, the opaque silica glass layer 51 and the transparent silica glass layer 52), depends on the intended use, but it is preferable that the silica (SiO₂) purity is 99.99% by mass or more in the silica container 72 for pulling a solar single crystal silicon and is 99.999% by mass or more in the silica container 72 for pulling single crystal silicon for LSIs.

Moreover, even when, for example, silica powder with a high impurity concentration, the silica powder containing about 10 ppm by mass of alkali metal elements Li, Na, and K, is used as raw material powder from which the opaque silica glass layer 51 and the transparent silica glass layer 52 are produced, by setting the OH group concentration at 30 to 100 ppm by mass in the opaque silica glass layer 51 and the transparent silica glass layer 52 and, at the same time, setting the Al concentration at 5 to 30 ppm by mass, it becomes possible to adsorb and confine these elements with large diffusion constant values in the thickness of the silica container. As the effect of the OH group in the silica glass, it has the good effect of adsorbing and fixing the metal impurity element but has the negative effect of increasing the amount of etching by the silicon melt at a high temperature. Therefore, in the straight body portion of the opaque silica glass layer 51 and the transparent silica glass layer 52, it is preferable to set the OH group concentration at 30 to 100 ppm by mass as described above. Moreover, in the bottom portion of the opaque silica glass layer 51 and the transparent silica glass layer 52, the bottom portion whose temperature becomes higher than the other portions while single crystal silicon is being pulled upwardly, it is preferable to set the OH group concentration at 30 to 50 ppm by mass. As for Al, it has the effect of adsorbing and fixing the metal impurity element and the good effect of increasing the viscosity of the silica glass at a high temperature, but has the negative effect of contaminating silicon with Al, the silicon which is an object to be processed. Therefore, when Al is added to the opaque silica glass layer 51 and the transparent silica glass layer 52, it is preferable to set the concentration thereof at 5 to 30 ppm by mass as described earlier, and it is more preferable to set the concentration thereof at 10 to 20 ppm by mass.

The details of the mechanism of how these Al and the OH group prevent the impurity metal elements from moving and diffusing in the silica glass is unknown, but it can be considered that Al adsorbs positive ions (cations) of the impurity metal elements and suppresses diffusion of them in order to keep electric charge balance of a silica glass network when Al is replaced by Si. Moreover, it is estimated that the OH group produces the effect of adsorbing the impurity metal elements or preventing diffusion thereof by the replacement of a metal ion with a hydrogen ion.

Hereinafter, a method for producing a silica container for pulling single crystal silicon, the method of the present invention that can produce the above-described silica container and 72, will be described specifically.

A method for producing the silica container 72 depicted in FIG. 1 will be described with reference to FIG. 2.

First, as described in (1) of FIG. 2, raw material powder is prepared. Here, as first raw material powder 11, silica powder with a particle size of 10 to 1000 µm is made. Moreover, as second raw material powder 12, silica powder with a particle size of 10 to 1000 µm, the silica powder containing the OH group in a concentration of more than 300 ppm by mass but 3000 ppm by mass or less, is made. Incidentally, the second raw material powder 12 may be made before a step of forming a silica glass layer with a high OH group concentration, which will be described later.

### (Making of first raw material powder)

The first raw material powder 11 can be made by crushing silica stone blocks and regulating the particle size in the following way, for example, but a way to make it is not limited thereto.

First, natural silica stone blocks (naturally-produced rock crystal, quartz, silica stones, siliceous rocks, opal, or the like) with a diameter of about 5 to 50 mm are heated for about 1 to 10 hours in the air atmosphere in the 600 to 1000°C temperature range. Then, the natural silica stone blocks are put in water, rapidly cooled, and then taken out of the water and dried. This processing makes it possible to perform easily the next processing: crushing by a crusher or the like and particle size regulation, but the procedure may proceed to crushing processing without the heating and rapid-cooling processing.

Next, the natural silica stone blocks are crushed by a crusher or the like and are subjected to particle size regulation to adjust the particle size to 10 to 1000 µm, preferably, 50 to 500 µm, whereby natural silica stone powder is obtained.

Then, the natural silica stone powder is charged into a rotary kiln formed of a silica glass tube with an inclination angle, and the inside of the kiln is made to have an atmosphere containing hydrogen chloride (HCl) or chlorine (Cl₂) gas, and heating is performed for about 1 to 100 hours at 800 to 1100°C, whereby processing to increase the degree of purity is performed. However, in the use of a product in which high purity is not required, the procedure may proceed to the next processing without the processing to increase the degree of purity.

The first raw material powder 11 obtained after the above-described steps is crystalline silica, but, depending on the intended purpose of the silica container, as the first raw material powder 11, amorphous silica glass powder can be used alone or by being mixed thereinto.

As described earlier, the particle size of the first raw material powder 11 is set at 10 to 1000 µm, and it is preferable to set the particle size of the first raw material powder 11 at 50 to 500 µm. Preferably, the first raw material powder 11 has a silica purity (SiO₂) of 99.99% by mass or more, and, more preferably, the first raw material powder 11 has a silica purity (SiO₂) of 99.999% by mass or more.

When the purity of the first raw material powder 11 is low (poor), to prevent movement and diffusion of impurity metal elements from the produced silica container to the inner surface and eventually to silicon to be housed therein, it is preferable to add predetermined amounts of Al and the OH group to the first raw material powder 11. Al can be obtained by using a water or alcohol solution of, e.g., a nitrate, an acetate, a carbonate, a chloride, or the like, putting and immersing the silica powder in such a solution, and then performing drying. The OH group is originally contained in the natural silica stone, or water which is mixed in an intermediate step can be adjusted by the gas atmosphere, the processing temperature, and the time in a subsequent drying step.

### (Making of second raw material powder)

The second raw material powder 12 is a material of the silica glass layer 59 with the high OH group concentration, the silica glass layer 59 which is formed in an inner surface portion of the bottom portion 63 of the silica container 72 of FIG. 1. Examples of the material of the second raw material powder 12 include the following: purified natural quartz powder, purified natural rock crystal powder, or purified cristobalite powder, which is obtained by the steps of: forming silica glass blocks containing the OH group in high concentration by the oxyhydrogen flame melting, and then performing crushing thereof and particle size regulation; and silica glass powder, which is obtained by the steps of: forming synthetic silica glass blocks with a high OH group concentration by processing a silicon compound such as silicon tetrachloride (SiCl₄) by an oxyhydrogen flame hydrolysis method, and then performing crushing thereof and particle size regulation.

The OH group concentration of the second raw material powder 12 is set at more than 300 ppm by mass but 3000 ppm by mass or less as described earlier. It is preferable to set the OH group concentration at 500 ppm by mass or more but 1500 ppm by mass or less. The OH group concentration of the second raw material powder can be adjusted by using various publicly known methods. For example, in the case of making by the oxyhydrogen flame hydrolysis method performed on silicon tetrachloride, by increasing the rates of flow of oxygen and hydrogen as compared to the rate of flow of silicon tetrachloride which is the material, it is possible to increase the OH group concentration in the second raw material powder 12. Moreover, in the case of melting of natural quartz powder, natural rock crystal powder, or cristobalite powder by using oxyhydrogen flame, the natural quartz powder, the natural rock crystal powder, and the cristobalite powder which were subjected to processing to increase the degree of purity, by adjusting the rates of flow of oxygen and hydrogen of the oxyhydrogen flame, it is possible to adjust the OH group concentration in the second raw material powder 12.

As described earlier, the particle size of the second raw material powder 12 is 10 to 1000 µm and preferably 100 to 500 µm. It is preferable that the purity of the second raw material powder 12 is set at a silica component (SiO₂) of greater than or equal to 99.9999% by mass, and, more specifically, it is preferable that the impurity concentrations of the second raw material powder 12 are set at 100 ppb by mass or less for each of Li, Na, and K, 50 ppb by mass or less for each of Ca and Mg, and 20 ppb by mass or less for each of Ti, Cr, Fe, Ni, Cu, Zn, Zr, Mo, W, and Pb. Such impurity concentrations can be easily obtained by using synthetic silica glass powder as the second raw material powder 12. It is more preferable that the impurity concentrations of the second raw material powder 12 are set at 50 ppb by mass or less for each of Li, Na, and K, at 25 ppb by mass or less for each of Ca and Mg, and at 10 ppb by mass or less for each of Ti, Cr, Fe, Ni, Cu, Zn, Zr, Mo, W, and Pb.

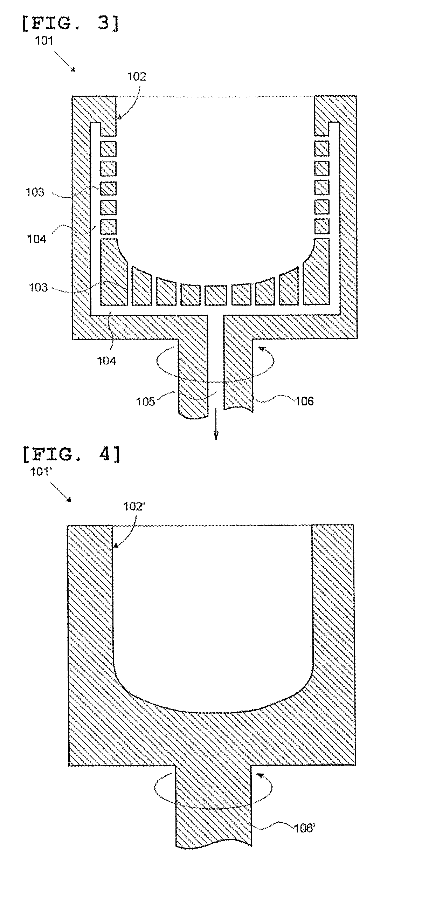

After at least the first raw material powder 11 is made, as described in (2) of FIG. 2, the first raw material powder 11 is charged into a mold having rotational symmetry and is temporarily molded into a predetermined shape corresponding to the inner wall of the mold concurrently with the rotation of the mold, whereby a temporary compact 41 made of the first raw material powder is obtained. In FIGS. 3 and 4, sectional views of the outlines of molds for temporarily molding the first raw material powder 11 are depicted. Molds 101 and 101' used in the present invention are made of heat-resistant ceramic such as graphite or alumina, have rotational symmetry, and can be rotated by a motor (not shown) for rotating a mold. Moreover, as depicted in FIG. 3, in an inner wall 102 of the mold 101, holes 103 for pressure reduction may be distributed and formed. The holes 103 for pressure reduction lead to a passage 104 for pressure reduction. Furthermore, a passage 105 for pressure reduction is formed through a rotating shaft 106 for rotating the mold 101, which makes it possible to perform vacuuming through this passage. In the present invention, the mold 101' provided with no equipment for pressure reduction as depicted in FIG. 4 can also be used. A hole for pressure reduction is not formed in an inner wall 102' of the mold 101', and a rotating shaft 106' is not provided with a passage for pressure reduction. In the following description, a case in which the mold 101 depicted in FIG. 3 is used will be described as an example, but the mold 101' depicted in FIG. 4 can also be used in the same manner except that pressure reduction is not performed.

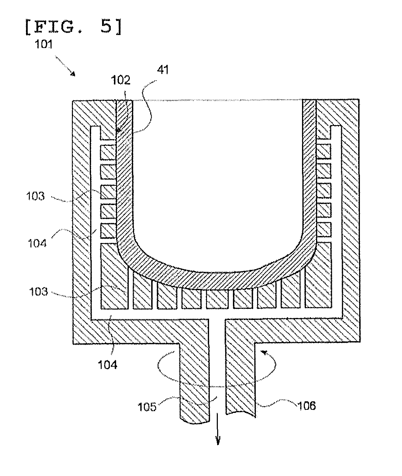

In a step described in (2) of FIG. 2, the first raw material powder 11 is introduced into the inner wall 102 of the mold 101 depicted in FIG. 3, and the first raw material powder 11 is temporarily molded into a predetermined shape corresponding to the inner wall 102 of the mold 101, whereby the temporary compact 41 made of the first raw material powder is obtained (refer to FIG. 5). Specifically, the first raw material powder 11 is gradually charged into the inner wall 102 of the mold 101 concurrently with the rotation of the mold 101 and is molded into the shape of a container by using a centrifugal force. Moreover, the thickness of the temporary compact 41 made of the first raw material powder may be adjusted to a predetermined thickness by bringing a plate-like inner mold (not shown) into contact with the rotating powder from inside. Furthermore, the method for supplying the first raw material powder 11 to the mold 101 is not limited to a particular method; for example, a hopper provided with a stirring screw and a metering feeder can be used. In this case, the first raw material powder 11 with which the hopper is filled is stirred with the stirring screw and is supplied concurrently with an adjustment of the supplied amount by the metering feeder.

Next, as described in (3) of FIG. 2, the temporary compact 41 made of the first raw material powder is heated from inside by the discharge heating melting method concurrently with the rotation of the mold 101. In this way, a silica container whose outside is made of opaque silica glass containing gaseous bubbles and inside is made of transparent silica glass containing substantially no gaseous bubble, the silica container having a straight body portion, a curved portion, and a bottom portion, is made. It is preferable to perform heating of the temporary compact made of the first raw material powder while performing pressure reduction from the outside of the temporary compact 41 made of the first raw material powder.

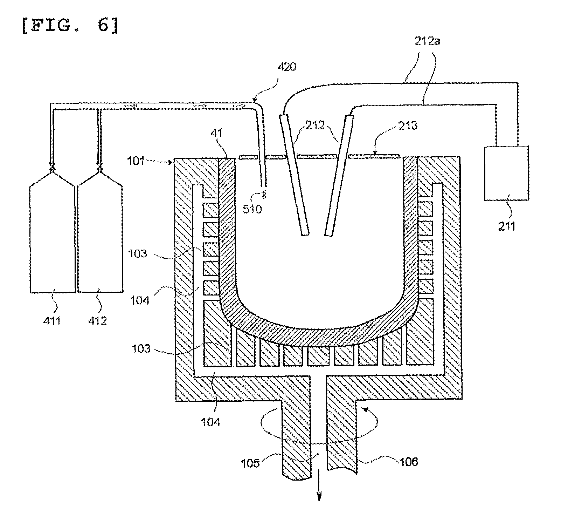

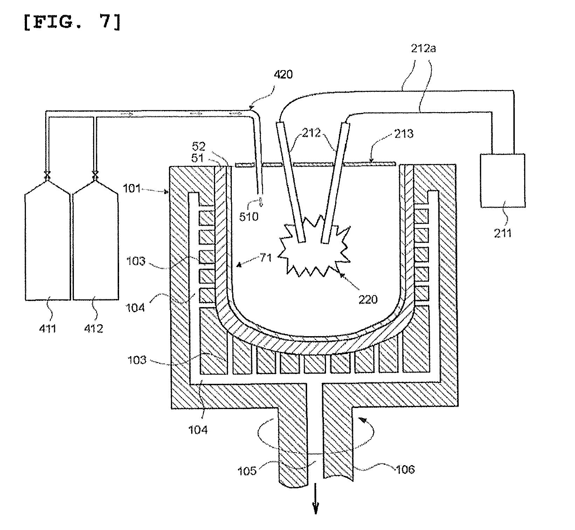

The state of this step is depicted specifically in FIGS. 6 and 7. An apparatus for making a silica container 71 is formed of, in addition to the above-described rotatable mold 101 having rotation axis symmetry, a rotary motor (not shown), carbon electrodes (carbon electrodes) 212 which become a heat source of discharge heating melting (also called arc melting and arc discharge melting), electric wires 212a, a high-voltage power supply unit 211, a lid 213, and the like. Furthermore, the apparatus is provided with components for adjusting the atmospheric gas that is supplied from the inside of the temporary compact 41 made of the first raw material powder, for example, a hydrogen gas supply cylinder 411, an inert gas supply cylinder 412, a mixed gas supply pipe 420, and the like.

Incidentally, this apparatus can also be used continuously when the silica glass layer 59 is further formed in an inner surface portion of the bottom portion of the silica container 71 as will be described later.

As a procedure for melting and sintering the temporary compact 41 made of the first raw material powder, it is preferable to supply gas containing hydrogen from the inside of the temporary compact 41 made of the first raw material powder before applying voltage between the carbon electrodes 212. Specifically, as depicted in FIG. 6, hydrogen gas is supplied from the hydrogen gas supply cylinder 411, inert gas (for example, nitrogen (N₂), argon (Ar), or helium (He)) is supplied from the inert gas supply cylinder 412, and these gases are mixed and supplied from the inside of the temporary compact 41 made of the first raw material powder through the mixed gas supply pipe 420. Incidentally, an arrow outline with a blank inside, the arrow identified with character 510, indicates the flow of the mixed gas.

Next, in a state in which the mixed gas is continuously supplied in the manner described above, while the mold 101 having the temporary compact 41 made of the first raw material powder inside is rotated at a constant rate, a vacuum pump for degassing (not shown) is started to reduce the pressure from the outside of the temporary compact 41 made of the first raw material powder through the holes 103 for pressure reduction and the passages 104 and 105 for pressure reduction, and the application of voltage between the carbon electrodes 212 is started.

When arc discharge (identified with character 220 in FIG. 7) between the carbon electrodes 212 is started, an inner surface part of the temporary compact 41 made of the first raw material powder reaches a silica powder melting temperature range (which is estimated to be about 1800 to 2000°C), and melting starts from an outermost surface layer part. When the outermost surface layer part is melted, the degree of reduced pressure of vacuuming by the degassing vacuum pump is increased (the pressure is suddenly lowered), a change into a molten silica glass layer progresses from the inside to the outside concurrently with degassing of dissolved gas such as water and oxygen contained in the first raw material powder 11.

Heating by the application of voltage is continuously performed until about half of the inside of the entire thickness of the temporary compact 41 made of the first raw material powder is melted and becomes transparent to translucent silica glass and about half of the remaining outside becomes sintered opaque silica.

The atmospheric gas inside a container thickness layer at the time of discharge heating melting may have inert gas such as nitrogen gas (N₂), argon (Ar), and helium (He) as the main ingredient for the purpose of reducing the wearing out of the carbon electrodes, but, to reduce the dissolved gas in the melted silica glass, as described above, in this step, it is preferable to use the gas containing hydrogen as the atmospheric gas. As the gas containing hydrogen, for example, mixed gas of hydrogen gas and inert gas such as nitrogen gas (N₂), argon (Ar), or helium (He) can be used. Preferably, the content ratio of the hydrogen gas (H₂) is set at 1% by volume or more and, more preferably, at 1 to 10% by volume. The reason is as follows: for example, the oxygen gas (O₂) which is difficult to be degassed reacts with hydrogen to form water (H₂O), and, since the diffusion constant of a water molecule is larger than that of an oxygen molecule, the water molecule is considered to be easily released to the outside of the external layer. Moreover, since the molecule radius of hydrogen gas (H₂) is small and the hydrogen gas (H₂) has a large diffusion constant, even when the hydrogen gas (H₂) is contained in the atmospheric gas, the hydrogen gas (H₂) is easily released to the outside of the external layer.

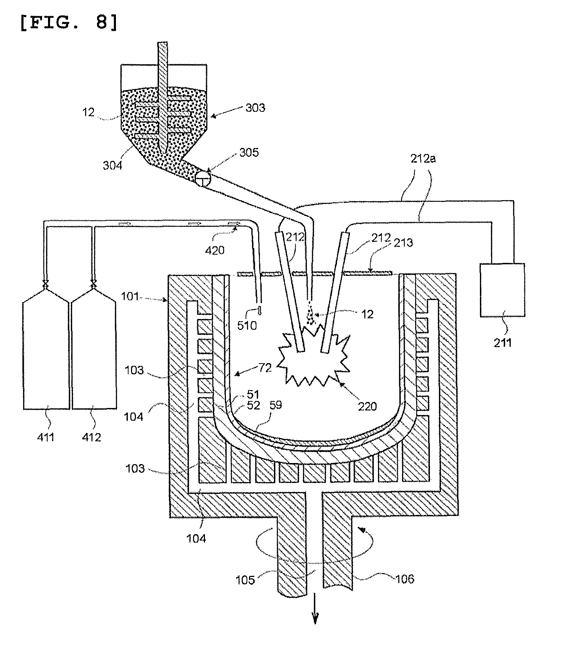

By the above steps, the silica container 71 having the opaque silica glass layer 51 and the transparent silica glass layer 52 is produced (refer to FIG. 7). Next, as described in FIG. 2 (4) and FIG. 8, the second raw material powder 12 is melted by the discharge heating melting method while being spread into the space in the silica container 71 thus made, and the melted second raw material powder 12 is made to adhere to the inner surface portion of the bottom portion of the silica container 71, whereby the silica glass layer 59 is formed in the inner surface portion of the bottom portion of the silica container 71. As a result, it is possible to produce the silica container 72 of the present invention, the silica container 72 depicted in FIG. 1. Since the second raw material powder 12 with a high OH group concentration is used, the silica glass layer 59 formed here also becomes a layer with a high OH group concentration. The basic method for forming the silica glass layer 59 with a high OH group concentration by this step is similar to the descriptions of Patent Literature 1 and Patent Literature 2, for example, but the feature of the present invention is that the silica glass layer 59 with a high OH group concentration is formed mainly in the bottom portion of the silica container 71. It is preferable that a region in which the silica glass layer 59 with a high OH group concentration, the silica glass layer 59 formed in the inner surface portion of the bottom portion, is formed has a diameter which is 1/3 or more of the outside diameter of the silica containers 71 and 72.

An apparatus for forming the silica glass layer 59, described in FIG. 8, with a high OH group concentration in the inner surface portion of the bottom portion of the silica container 71 is almost the same as that used in the previous step and is formed of a rotatable mold 101 having rotation axis symmetry, the mold 101 in which the silica container 72 is placed, a rotary motor (not shown), a raw material powder hopper 303 containing the second raw material powder 12, a stirring screw 304, a metering feeder 305, carbon electrodes 212 which become a heat source of discharge heating melting, electric wires 212a, a high-voltage power supply unit 211, a lid 213, and the like. Moreover, when the atmospheric gas is adjusted, as is the case with the previous step, the apparatus may be further provided with a hydrogen gas supply cylinder 411, an inert gas supply cylinder 412, a mixed gas supply pipe 420, and the like.

As the method for forming the silica glass layer 59 with a high OH group concentration, first, the mold 101 is set at a predetermined rotation speed, high voltage is gradually applied from the high-voltage power supply unit 211 and, at the same time, the second raw material powder 12 is gradually spread from the raw material hopper 303 from an upper part of the silica container 71. At this time, since discharge has already started between the carbon electrodes 212 and the inside of the silica container 71 is in the silica powder melting temperature range (which is estimated to be about 1800 to 2000°C), the spread second raw material powder 12 becomes silica molten particles and begins to adhere to the inner surface of the silica container 71. The carbon electrodes 212, a raw material powder input port, and the lid 213 that are placed in an upper opening of the silica container 71 are mechanisms whose positions can be changed to some extent with respect to the silica container 71, and, by changing these positions, it is possible to form the silica glass layer 59 with a high OH group concentration in a predetermined position of the bottom portion of the silica container 71 in a predetermined thickness.

The atmospheric gas inside the silica container 71 during arc discharge melting has inert gas such as nitrogen gas (N₂), argon (Ar), and helium (He) as the main ingredient to reduce the wearing out of the carbon electrodes, and, by using a mixed atmosphere containing 1 to 10% by volume of hydrogen gas (H₂), it is possible to obtain the silica glass layer 59 with a high OH group concentration, the silica glass layer 59 with fewer gaseous bubbles. Moreover, by adjusting the content of water (that is, humidity) in the atmospheric gas, it is also possible to adjust the OH group concentration of the silica glass layer 59.

If carbon fine particles which are generated at the time of arc discharge melting and carbon monoxide (CO) and carbon dioxide (CO₂) which are compounds made up of carbon and oxygen remain in the silica glass layer 59 with a high OH group concentration, they are regenerated as impurities when single crystal silicon is pulled upwardly and become one cause of a reduction in the quality of the silicon. To suppress this, it is preferable to ventilate the inside of the silica container during melting appropriately by exhausting the gas in the container at a constant flow rate while supplying clean atmospheric gas at a constant flow rate from the outside of the silica container.

### [Examples]

Hereinafter, the present invention will be described more specifically with examples and comparative examples of the present invention, but the present invention is not limited to these examples.

### (Example 1)

A silica container for pulling single crystal silicon was produced in accordance with the steps (1) to (4) described in FIG. 2. As the first raw material powder 11, a natural quartz powder having a particle size of 50 to 500 µm and purity of 99.999% by mass was prepared. The first raw material powder 11 was charged into the graphite mold 101 depicted in FIGS. 3 and 5 concurrently with the rotation of the graphite mold 101, whereby the temporary compact 41 made of the first raw material powder was obtained. Then, by using the apparatus depicted in FIGS. 6 and 7, discharge heating melting was performed in the temporary compact 41 made of the first raw material powder concurrently with suction under a reduced pressure from the periphery by using dried mixed gas of 95% by volume of N₂ and 5% by volume of H₂ as an inner atmosphere of the temporary compact 41 made of the first raw material powder. In this way, the silica container 71 whose outside was a white opaque silica sintered body and inside was a colorless transparent silica glass body was made. Next, as the second raw material powder 12, high-purity synthetic silica glass powder (second raw material powder a) having a particle size of 100 to 300 µm and containing 1500 ppm by mass of the OH group was prepared. Then, by using the apparatus depicted in FIG. 8, the silica glass layer 59 with a high OH group concentration was formed from the entire inner surface of the silica container bottom portion to part of the curved portion by performing discharge heating concurrently with the spreading of the second raw material powder from an upper part of the silica container 71 by using dried mixed gas of 95% by volume of N₂ and 5% by volume of H₂ as an atmosphere, whereby the silica container 72 was produced. The thickness of the silica glass layer 59 with a high OH group concentration was set at a thickness of 450 µm in a central portion of the bottom portion.

### (Example 2)

By using the same second raw material powder 12 (second raw material powder a, a synthetic silica glass powder) as that of Example 1, a silica container was produced in basically the same manner as in Example 1, but the following changes were made. The first raw material powder 11 was obtained by mixing an aluminum nitrate solution to the first raw material powder 11 which was identical to that of Example 1 and drying it to add 10 ppm by mass of Al thereto. As an atmosphere at the time of discharge heating, dried mixed gas of 99% by volume of N₂ and 1% by volume of H₂ was used. The thickness of the silica glass layer 59 with a high OH group concentration, the silica glass layer 59 in a central portion of the container bottom portion, was set at 80 µm.

### (Example 3)

By using the same first raw material powder 11 as that of Example 1, a silica container was produced in basically the same manner as in Example 1, but the following changes were made. As the second raw material powder 12, high-purity synthetic silica glass powder (second raw material powder b) containing 550 ppm by mass of the OH group was used. The silica glass layer 59 with a high OH group concentration was made from the entire inner surface of the container bottom portion to the curved portion and was formed to have a thickness of 460 µm in a central portion of the container bottom portion.

### (Example 4)

By using the same first raw material powder 11 as that of Example 2, a silica container was produced in basically the same manner as in Example 2, but the following changes were made. As the second raw material powder 12, as is the case with Example 3, high-purity synthetic silica glass powder (second raw material powder b) containing 550 ppm by mass of the OH group was used. The thickness of the silica glass layer 59 with a high OH group concentration, the silica glass layer 59 in a central portion of the container bottom portion, was set at 90 µm.

### (Example 5)

By using the same first raw material powder 11 as that of Example 1, a silica container was produced in basically the same manner as in Example 1, but the following changes were made. As the second raw material powder 12, high-purity synthetic silica glass powder (second raw material powder c) containing 350 ppm by mass of the OH group was used. The silica glass layer 59 with a high OH group concentration was made from the entire inner surface of the container bottom portion to the curved portion and was formed to have a thickness of 450 µm in a central portion of the container bottom portion.

### (Example 6)

By using the same first raw material powder 11 as that of Example 2, a silica container was produced in basically the same manner as in Example 2, but the following changes were made. As the second raw material powder 12, as is the case with Example 5, high-purity synthetic silica glass powder (second raw material powder c) containing 350 ppm by mass of the OH group was used. The thickness of the silica glass layer 59 with a high OH group concentration, the silica glass layer 59 in a central portion of the container bottom portion, was set at 90 µm.

### (Example 7)

A silica container was produced in basically the same manner as in Example 3, but the thickness of the silica glass layer 59 with a high OH group concentration, the silica glass layer 59 in a central portion of the container bottom portion, was set at 25 µm.

### (Example 8)

A silica container was produced in basically the same manner as in Example 3, but the thickness of the silica glass layer 59 with a high OH group concentration, the silica glass layer 59 in a central portion of the container bottom portion, was set at 50 µm.

### (Example 9)

A silica container was produced in basically the same manner as in Example 3, but the thickness of the silica glass layer 59 with a high OH group concentration, the silica glass layer 59 in a central portion of the container bottom portion, was set at 1000 µm.

### (Example 10)

By using the same first raw material powder 11 and second raw material powder 12 as those of Example 1, a silica container was produced in basically the same manner as in Example 1, but the following changes were made. As an atmosphere at the time of discharge heating, dried mixed gas of 90% by volume of He and 10% by volume of H₂ was used. The thickness of the silica glass layer 59 with a high OH group concentration, the silica glass layer 59 in a central portion of the container bottom portion, was set at 230 µm.

### (Comparative Example 1)

As the first raw material powder, a natural quartz powder (having a particle size of 100 to 300 µm) was prepared, but addition of Al was not performed. By using this first raw material powder, under the same conditions as those of Example 2, a silica container 71 whose outside was a white opaque silica sintered body and inside was a colorless transparent silica glass body was made. However, the equivalent of the second raw material powder 12 was not prepared, and a silica glass layer with a high OH group concentration was not formed on the inner surface of the container bottom portion.

### (Comparative Example 2)

A silica container was produced in basically the same manner as in Example 2, but the following changes were made. As the first raw material powder, the first raw material powder which was identical to that of Comparative Example 1 was used. As the second raw material powder, high-purity synthetic silica glass powder (second raw material powder d) with fewer OH groups, the high-purity synthetic silica glass powder (second raw material powder d) containing only 100 ppm by mass of the OH group, was prepared. The thickness of a silica glass layer made of the second raw material powder, the silica glass layer in a central portion of the container bottom portion, was set at 90 µm.

### (Comparative Example 3)

A silica container was produced in basically the same manner as in Comparative Example 2, but the OH group concentration of the second raw material powder was set at 250 ppm by mass (second raw material powder e). The thickness of a silica glass layer made of the second raw material powder, the silica glass layer in a central portion of the container bottom portion, was set at 90 µm.

### (Comparative Example 4)

A silica container was produced in basically the same manner as in Comparative Example 2, but the OH group concentration of the second raw material powder was set at 300 ppm by mass (second raw material powder f). The thickness of a silica glass layer made of the second raw material powder, the silica glass layer in a central portion of the container bottom portion, was set at 90 µm.

### (Comparative Example 5)

A silica container was produced in basically the same manner as in Example 1, but, as the first raw material powder, the first raw material powder which was identical to that of Comparative Example 1 was used. The thickness of a silica glass layer made of the same second raw material powder as that of Example 1, the silica glass layer in a central portion of the container bottom portion, was set at 1520 µm.

### [Evaluation method in the examples and the comparative examples]

The physical property and characteristic evaluations of the raw material powder used and the produced silica containers in the examples and comparative examples were performed in the following manner.

The method for measuring the particle size of each raw material powder:
Observation of the two-dimensional shape and measurement of the area of each raw material powder were performed by an optical microscope or an electron microscope. Then, on the assumption that the shape of a particle was a perfect circle, the diameter was calculated and determined based on the value of the area thereof. This method was repeatedly performed statistically, and the obtained values are listed in Tables 1 to 5 as the values in the particle size range (99% by mass or more of each raw material powder is included in this range).

Measurement of the layer thickness of a silica container:
The thickness was determined by cutting the silica container with a cutter and measuring the cross section thereof by using a scale.

Measurement of the OH group concentration:
Measurement of the OH group concentration was performed by the infrared absorption spectrophotometry. The conversion into the OH group concentration was performed in accordance with the following document: Dodd, D. M. and Fraser, D. B. (1966) Optical determination of OH in fused silica. Journal of Applied Physics, vol. 37, P. 3911.

Incidentally, it was estimated that the OH group concentrations of the silica glass layers formed in the silica container bottom portions in Examples 1 to 6 and Comparative Examples 2 to 4 were equivalent to the measurement values of the OH group concentrations of the raw material powder used in the examples and the comparative examples.

Impurity metal element concentration analysis:
When an impurity metal element concentration was relatively low (when the glass was high-purity glass), analysis was conducted by plasma emission spectroscopy (ICP-AES) or plasma mass spectrometry (ICP-MS), and, when an impurity metal element concentration was relatively high (when the glass was low-purity glass), analysis was conducted by atomic absorption spectroscopy (AAS). The results on 15 elements: alkali metal elements Li, Na, and K, alkaline earth metal elements Ca and Mg, and transition metal elements Ti, Cr, Fe, Ni, Cu, Zn, Zr, Mo, W, and Pb are listed in Table 6.

Evaluation of continuous pulling (multiple pulling operations) of single crystal silicon:
Metal polysilicon having a purity of 99.99999% by mass was charged into the produced silica container, the temperature was raised to turn the metal polysilicon into silicon melt, pulling of single crystal silicon was repeatedly performed three times (multiple pulling operations), and evaluations were made as the success rate of the growth of single crystal silicon. The pulling conditions were as follows: the inside of a pulling apparatus (a CZ apparatus) was put under an atmosphere containing 100% of argon (Ar) gas, the pulling rate was set at 1.2 mm/minute, the measurements of single crystal silicon was 300 mm in diameter and 600 mm in length, and the hour of operation of 1 batch was set at about 48 hours. A classification of the success ratio of three repeated single crystal silicon growth operations was made as follows.

| | |
|---|---|
| 3 times | ○ (favorable) |
| 2 times | Δ (slightly poor) |
| 1 time | × (poor) |

Evaluations of voids and pinholes in single crystal silicon:
In the above-described continuous pulling of single crystal silicon, from an arbitrary area of the first single crystal silicon after completion of multiple pulling operations of each single crystal silicon, 200 silicon wafers, each being 300 mm in diameter and 200 µm in thickness, the silicon wafers with both faces polished to a mirror-smooth state, were made. Then, the number of voids and pinholes that were present in both faces of each silicon wafer were measured by a particle detector and numerical processing was statistically performed to determine the number of wafers containing no defect, the wafers of the 200 silicon wafers. As a result, the following evaluations were made according to the number of silicon wafers from which neither void nor pinhole was detected. However, the diameter of a detectable void and a detectable pinhole was 50 µm or more.

| | |
|---|---|
| The number of defect-free silicon wafers 200 | ○ (favorable) |
| The number of defect-free silicon wafers 199 to 198 | Δ (slightly poor) |
| The number of defect-free silicon wafers 197 or less | × (poor) |

The production conditions of the silica containers produced in Examples 1 to 10 and Comparative Examples 1 to 5, the measured physical property values, and the evaluations results are combined and listed in the following Tables 1 to 9.

**[Table 1]**

| Example number | | Example 1 | Example 2 |
|---|---|---|---|
| First raw material powder | | Natural quartz powder with particle size of 50 to 500 µm | Natural quartz powder with particle size of 50 to 500 µm |
| Second raw material powder | | (a) Synthetic silica glass powder with particle size of 100 to 300 µm | (a) Synthetic silica glass powder with particle size of 100 to 300 µm |
| Molding method | | Rotational molding method in graphite mold | Rotational molding method in graphite mold |
| Melting method | | Reduced-pressure arc discharge melting method | Reduced-pressure arc discharge melting method |
| Melting atmospheric gas | | N₂: 95% by volume, H₂: 5% by volume | N₂: 99% by volume, H₂: 1% by volume |
| Atmospheric gas at the time of cooling | | N₂: 80% by volume, O₂: 20% by volume | N₂: 80% by volume, O₂: 20% by volume |
| Physical properties of a straight body portion | Color tone | Outside white and opaque, inside colorless and transparent | Outside white and opaque, inside colorless and transparent |
| | Outside diameter, height, thickness (mm) | Outside diameter 800 | Outside diameter 800 |
| | | × Height 360 | × Height 360 |
| | | × Thickness 17 | × Thickness 17 |
| | OH group (ppm by mass) | 10 (thickness central portion) | 22 (thickness central portion) |
| | Al (ppm by mass) | 2 (thickness central portion) | 10 (thickness central portion) |
| Physical properties of a bottom portion | Color tone | Outside white and opaque, inside colorless and transparent | Outside white and opaque, inside colorless and transparent |
| | Thickness (mm) | Thickness 17 | Thickness 17 |
| | OH group (ppm by mass) | 10 (thickness central portion) | 18 (thickness central portion) |
| | Al (ppm by mass) | 2 (thickness central portion) | 10 (thickness central portion) |
| | Thickness of an inner-surface silica glass layer (µm) | 450 | 80 |
| | OH group concentration of an inner-surface silica glass layer (ppm by mass) | 1500 | 1500 |
| Evaluations | Single crystal multiple pulling operations | ○ | ○ |
| | Voids and pinholes | ○ | ○ |

**[Table 2]**

| Example number | | Example 3 | Example 4 |
|---|---|---|---|
| First raw material powder | | Natural quartz powder with particle size of 50 to 500 µm | Natural quartz powder with particle size of 50 to 500 µm |
| Second raw material powder | | (b) Synthetic silica glass powder with particle size of 100 to 300 µm | (b) Synthetic silica glass powder with particle size of 100 to 300 µm |
| Molding method | | Rotational molding method in graphite mold | Rotational molding method in graphite mold |
| Melting method | | Reduced-pressure arc discharge melting method | Reduced-pressure arc discharge melting method |
| Melting atmospheric gas | | N₂: 95% by volume, H₂: 5% by volume | N₂: 99% by volume, H₂: 1% by volume |
| Atmospheric gas at the time of cooling | | N₂: 80% by volume, O₂: 20% by volume | N₂: 80% by volume, O₂: 20% by volume |
| Physical properties of a straight body portion | Color tone | Outside white and opaque, inside colorless and transparent | Outside white and opaque, inside colorless and transparent |
| | Outside diameter, height, thickness (mm) | Outside diameter 800 | Outside diameter800 |
| | | × Height 360 | × Height 360 |
| | | × Thickness 17 | × Thickness 17 |
| | OH group (ppm by mass) | 12 (thickness central portion) | 25 (thickness central portion) |
| | Al (ppm by mass) | 2 (thickness central portion) | 10 (thickness central portion) |
| Physical properties of a bottom portion | Color tone | Outside white and opaque, inside colorless and transparent | Outside white and opaque, inside colorless and transparent |
| | Thickness (mm) | Thickness 17 | Thickness 17 |
| | OH group (ppm by mass) | 10 (thickness central portion) | 20 (thickness central portion) |
| | Al (ppm by mass) | 2 (thickness central portion) | 10 (thickness central portion) |
| | Thickness of an inner-surface silica glass layer (µm) | 460 | 90 |
| | OH group concentration of an inner-surface silica glass layer (ppm by mass) | 550 | 550 |
| Evaluations | Single crystal multiple pulling operations | ○ | ○ |
| | Voids and pinholes | ○ | ○ |

**[Table 3]**

| Example number | | Example 5 | Example 6 |
|---|---|---|---|
| First raw material powder | | Natural quartz powder with particle size of 50 to 500 µm | Natural quartz powder with particle size of 50 to 500 µm |
| Second raw material powder | | (c) Synthetic silica glass powder with particle size of 100 to 300 µm | (c) Synthetic silica glass powder with particle size of 100 to 300 µm |
| Molding method | | Rotational molding method in graphite mold | Rotational molding method in graphite mold |
| Melting method | | Reduced-pressure arc discharge melting method | Reduced-pressure arc discharge melting method |
| Melting atmospheric gas | | N₂: 95% by volume, H₂: 5% by volume | N₂: 99% by volume, H₂: 1% by volume |
| Atmospheric gas at the time of cooling | | N₂: 80% by volume, O₂: 20% by volume | N₂: 80% by volume, O₂: 20% by volume |
| Physical properties of a straight body portion | Color tone | Outside white and opaque, inside colorless and transparent | Outside white and opaque, inside colorless and transparent |
| | Outside diameter, height, thickness (mm) | Outside diameter 800 | Outside diameter 800 |
| | | × Height 360 | × Height 360 |
| | | × Thickness 17 | × Thickness 17 |
| | OH group (ppm by mass) | 12 (thickness central portion) | 25 (thickness central portion) |
| | Al (ppm by mass) | 2 (thickness central portion) | 10 (thickness central portion) |
| Physical properties of a bottom portion | Color tone | Outside white and opaque, inside colorless and transparent | Outside white and opaque, inside colorless and transparent |
| | Thickness (mm) | Thickness 17 | Thickness 17 |
| | OH group (ppm by mass) | 10 (thickness central portion) | 20 (thickness central portion) |
| | Al (ppm by mass) | 2 (thickness central portion) | 10 (thickness central portion) |
| | Thickness of an inner-surface silica glass layer (µm) | 450 | 90 |
| | OH group concentration of an inner-surface silica glass layer (ppm by mass) | 350 | 350 |
| Evaluations | Single crystal multiple pulling operations | ○ | Δ |
| | Voids and pinholes | Δ | Δ |

**[Table 4]**

| Example number | | Example 7 | Example 8 |
|---|---|---|---|
| First raw material powder | | Natural quartz powder with particle size of 50 to 500 µm | Natural quartz powder particle size 50 to 500 µm |
| Second raw material powder | | (b) Synthetic silica glass powder with particle size of 100 to 300 µm | (b) Synthetic silica glass powder with particle size of 100 to 300 µm |
| Molding method | | Rotational molding method in graphite mold | Rotational molding method in graphite mold |
| Melting method | | Reduced-pressure arc discharge melting method | Reduced-pressure arc discharge melting method |
| Melting atmospheric gas | | N₂: 95% by volume, H₂: 5% by volume | N₂: 95% by volume, H₂: 5% by volume |
| Atmospheric gas at the time of cooling | | N₂: 80% by volume, O₂: 20% by volume | N₂: 80% by volume, O₂: 20% by volume |
| Physical properties of a straight body portion | Color tone | Outside white and opaque, inside colorless and transparent | Outside white and opaque, inside colorless and transparent |
| | Outside diameter, height, thickness (mm) | Outside diameter 800 | Outside diameter 800 |
| | | × Height 360 | × Height 360 |
| | | × Thickness 17 | × Thickness 17 |
| | OH group (ppm by mass) | 13 (thickness central portion) | 12 (thickness central portion) |
| | Al (ppm by mass) | 2 (thickness central portion) | 2 (thickness central portion) |
| Physical properties of a bottom portion | Color tone | Outside white and opaque, inside colorless and transparent | Outside white and opaque, inside colorless and transparent |
| | Thickness (mm) | Thickness 17 | Thickness 17 |
| | OH group (ppm by mass) | 12 (thickness central portion) | 12 (thickness central portion) |
| | Al (ppm by mass) | 2 (thickness central portion) | 2 (thickness central portion) |
| | Thickness of an inner-surface silica glass layer (µm) | 25 | 50 |
| | OH group concentration of an inner-surface silica glass layer (ppm by mass) | 550 | 550 |
| Evaluations | Single crystal multiple pulling operations | ○ | ○ |
| | Voids and pinholes | Δ | ○ |

**[Table 5]**

| Example number | | Example 9 | Example 10 |
|---|---|---|---|
| First raw material powder | | Natural quartz powder with particle size of 50 to 500 µm | Natural quartz powder with particle size of 50 to 500 µm |
| Second raw material powder | | (b) Synthetic silica glass powder with particle size of 100 to 300 µm | (a) Synthetic silica glass powder with particle size of 100 to 300 µm |
| Molding method | | Rotational molding method in graphite mold | Rotational molding method in graphite mold |
| Melting method | | Reduced-pressure arc discharge melting method | Reduced-pressure arc discharge melting method |
| Melting atmospheric gas | | N₂: 95% by volume, H₂: 5% by volume | He: 90% by volume, H₂: 10% by volume |
| Atmospheric gas at the time of cooling | | N₂: 80% by volume, O₂: 20% by volume | N₂: 80% by volume, O₂: 20% by volume |
| Physical properties of a straight body portion | Color tone | Outside white and opaque, inside colorless and transparent | Outside white and opaque, inside colorless and transparent |
| | Outside diameter, height, thickness (mm) | Outside diameter 800 | Outside diameter 800 |
| | | × Height 360 | × Height 360 |
| | | × Thickness 17 | × Thickness 17 |
| | OH group (ppm by mass) | 15 (thickness central portion) | <3 (thickness central portion) |
| | Al (ppm by mass) | 2 (thickness central portion) | 10 (thickness central portion) |
| Physical properties of a bottom portion | Color tone | Outside white and opaque, inside colorless and transparent | Outside white and opaque, inside colorless and transparent |
| | Thickness (mm) | Thickness 17 | Thickness 17 |
| | OH group (ppm by mass) | 13 (thickness central portion) | <3 (thickness central portion) |
| | Al (ppm by mass) | 2 (thickness central portion) | 2 (thickness central portion) |
| | Thickness of an inner-surface silica glass layer (µm) | 1000 | 230 |
| | OH group concentration of an inner-surface silica glass layer (ppm by mass) | 550 | 1500 |
| Evaluations | Single crystal multiple pulling operations | ○ | ○ |
| | Voids and pinholes | Δ | ○ |

**[Table 6]**

| Example number | | Comparative Example 1 | Comparative Example 2 |
|---|---|---|---|
| First raw material powder | | Natural quartz powder with particle size of 100 to 300 µm | Natural quartz powder with particle size of 100 to 300 µm |
| Second raw material powder | | None | (d)Synthetic silica glass powder with particle size of 100 to 300 µm |
| Molding method | | Rotational molding method in graphite mold | Rotational molding method in graphite mold |
| Melting method | | Reduced-pressure arc discharge melting method | Reduced-pressure arc discharge melting method |
| Melting atmospheric gas | | N₂: 99% by volume, H₂: 1% by volume | N₂: 99% by volume, H₂: 1% by volume |
| Atmospheric gas at the time of cooling | | N₂: 80% by volume, O₂: 20% by volume | N₂: 80% by volume, O₂: 20% by volume |
| Physical properties of a straight body portion | Color tone | Outside white and opaque, inside colorless and transparent | Outside white and opaque, inside colorless and transparent |
| | Outside diameter, height, thickness (mm) | Outside diameter 800 | Outside diameter 800 |
| | | × Height 360 | × Height 360 |
| | | × Thickness 17 | × Thickness 17 |
| | OH group (ppm by mass) | 25 (thickness central portion) | 25 (thickness central portion) |
| | Al (ppm by mass) | 2 (thickness central portion) | 2 (thickness central portion) |
| Physical properties of a bottom portion | Color tone | Outside white and opaque, inside colorless and transparent | Outside white and opaque, inside colorless and transparent |
| | Thickness (mm) | Thickness 17 | Thickness 17 |
| | OH group (ppm by mass) | 20 (thickness central portion) | 25 (thickness central portion) |
| | Al (ppm by mass) | 2 (thickness central portion) | 2 (thickness central portion) |
| | Thickness of an inner-surface silica glass layer (µm) | 0 | 90 |
| | OH group concentration of an inner-surface silica glass layer (ppm by mass) | - | 100 |
| Evaluations | Single crystal multiple pulling operations | × | Δ |
| | Voids and pinholes | × | × |

**[Table 7]**

| Example number | | Comparative Example 3 | Comparative Example 4 |
|---|---|---|---|
| First raw material powder | | Natural quartz powder with particle size of 100 to 300 µm | Natural quartz powder with particle size of 100 to 300 µm |
| Second raw material powder | | (e) Synthetic silica glass powder, with particle size of 100 to 300 µm | (f) Synthetic silica glass powder, with particle size of 100 to 300 µm |
| Molding method | | Rotational molding method in graphite mold | Rotational molding method in graphite mold |
| Melting method | | Reduced-pressure arc discharge melting method | Reduced-pressure arc discharge melting method |
| Melting atmospheric gas | | N₂: 99% by volume, H₂: 1% by volume | N₂: 99% by volume, H₂: 1% by volume |
| Atmospheric gas at the time of cooling | | N₂: 80% by volume, O₂: 20% by volume | N₂: 80% by volume, O₂: 20% by volume |
| Physical properties of a straight body portion | Color tone | Outside white and opaque, inside colorless and transparent | Outside white and opaque, inside colorless and transparent |
| | Outside diameter, height, thickness (mm) | Outside diameter 800 | Outside diameter 800 |
| | | × Height 360 | × Height 360 |
| | | × Thickness 17 | × Thickness 17 |
| | OH group (ppm by mass) | 25 (thickness central portion) | 25 (thickness central portion) |
| | Al (ppm by mass) | 2 (thickness central portion) | 2 (thickness central portion) |
| Physical properties of a bottom portion | Color tone | Outside white and opaque, inside colorless and transparent | Outside white and opaque, inside colorless and transparent |
| | Thickness (mm) | Thickness 17 | Thickness 17 |
| | OH group (ppm by mass) | 20 (thickness central portion) | 25 (thickness central portion) |
| | Al (ppm by mass) | 2 (thickness central portion) | 2 (thickness central portion) |
| | Thickness of an inner-surface silica glass layer (µm) | 90 | 90 |
| | OH group concentration of an inner-surface silica glass layer (ppm by mass) | 250 | 300 |
| Evaluations | Single crystal multiple pulling operations | Δ | Δ |
| | Voids and pinholes | × | × |

**[Table 8]**

| Example number | | Comparative Example 5 |
|---|---|---|
| First raw material powder | | Natural quartz powder with particle size of 100 to 300 µm |
| Second raw material powder | | (a) Synthetic silica glass powder, with particle size of 100 to 300 µm |
| Molding method | | Rotational molding method in graphite mold |
| Melting method | | Reduced-pressure arc discharge melting method |
| Melting atmospheric gas | | N₂: 99% by volume, H₂: 1% by volume |
| Atmospheric gas at the time of cooling | | N₂: 80% by volume, O₂: 20% by volume |
| Physical properties of a straight body portion | Color tone | Outside white and opaque, inside colorless and transparent |
| | Outside diameter, height, thickness (mm) | Outside diameter 800 |
| | | × Height 360 |
| | | × Thickness 17 |
| | OH group (ppm by mass) | 30 (thickness central portion) |
| | Al (ppm by mass) | 2 (thickness central portion) |
| Physical properties of a bottom portion | Color tone | Outside white and opaque, inside colorless and transparent |
| | Thickness (mm) | Thickness 17 |
| | OH group (ppm by mass) | 25 (thickness central portion) |
| | Al (ppm by mass) | 2 (thickness central portion) |
| | Thickness of an inner-surface silica glass layer (µm) | 1520 |
| | OH group concentration of an inner-surface silica glass layer (ppm by mass) | 1500 |
| Evaluations | Single crystal multiple pulling operations | Δ |
| | Voids and pinholes | × |

**[Table 9]**

| | | Examples 1, 2, 10, Comparative Example 5 | Examples 3, 4, 7, 8, 9 | Examples 5, 6 | Comparative Example 2 | Comparative Example 3 | Comparative Example 4 |
|---|---|---|---|---|---|---|---|
| Element concentration (ppb by mass) | First raw material powder | Second raw material powder a | Second raw material powder b | Second raw material powder c | Second raw material powder d | Second raw material powder e | Second raw material powder f |
| Li | 150 | 20 | 30 | 40 | 30 | 40 | 40 |
| Na | 1300 | 80 | 100 | 100 | 250 | 90 | 110 |
| K | 500 | 30 | 50 | 40 | 70 | 40 | 40 |
| Ca | 300 | 20 | 30 | 20 | 80 | 30 | 20 |
| Mg | 200 | 25 | 30 | 30 | 50 | 30 | 20 |
| Ti | 500 | 5 | 5 | 10 | 20 | 10 | 10 |
| Cr | 300 | 5 | 10 | 5 | 20 | 5 | 10 |
| Fe | 450 | 10 | 10 | 5 | 50 | 10 | 10 |
| Ni | 100 | 5 | 5 | 10 | 30 | 5 | 5 |
| Cu | 100 | 10 | 10 | 10 | 30 | 10 | 10 |
| Zn | 50 | 5 | <3 | <3 | 10 | 5 | 5 |
| Zr | 300 | <3 | <3 | <3 | 5 | <3 | <3 |
| Mo | 50 | <3 | <3 | <3 | 10 | <3 | <3 |
| W | 30 | <3 | <3 | <3 | 15 | <3 | <3 |
| Pb | 20 | <3 | <3 | <3 | 5 | <3 | <3 |
| OH group concentration (ppm by mass) | - | 1500 | 550 | 350 | 110 | 250 | 300 |

As is clear from Tables 1 to 9, in Examples 1 to 10, single crystal silicon with a small number of voids and pinholes could be produced. Moreover, as is clear from a comparison between, in particular, Examples 5 and 6 and Comparative Example 4, to obtain the effect of the present invention, the effect of reducing voids and pinholes in the pulled single crystal silicon, the OH group concentration of a silica glass layer formed in the silica container bottom portion is required to exceed 300 ppm by mass.

It is to be understood that the present invention is not limited in any way by the embodiment thereof described above. The above embodiment is merely an example, and anything that has substantially the same structure as the technical idea recited in the claims of the present invention and that offers similar workings and benefits falls within the technical scope of the present invention.

## Claims

1. A single-crystal silicon pulling silica container, the silica container comprising a straight body portion, a curved portion, and a bottom portion, wherein
an outside of the silica container is made of opaque silica glass containing gaseous bubbles,
an inside of the silica container is made of transparent silica glass containing substantially no gaseous bubble, and
on an inner surface of the bottom portion, a silica glass layer containing the OH group in a concentration of more than 300 ppm by mass but 3000 ppm by mass or less, the silica glass layer having a thickness of 20 µm or more but 1000 µm or less, is formed.

2. The single-crystal silicon pulling silica container according to claim 1, wherein
the silica glass layer formed on the inner surface of the bottom portion is made of synthetic silica glass.

3. The single-crystal silicon pulling silica container according to claim 1 or 2, wherein
the silica glass layer formed on the inner surface of the bottom portion contains the OH group in a concentration of 500 ppm by mass or more but 1500 ppm by mass or less and has a thickness of 50 µm or more but 500 µm or less.

4. The single-crystal silicon pulling silica container according to any one of claims 1 to 3, wherein
concentrations of impurities contained in the silica glass layer formed on the inner surface of the bottom portion are 100 ppb by mass or less for each of Li, Na, and K, 50 ppb by mass or less for each of Ca and Mg, and 20 ppb by mass or less for each of Ti, Cr, Fe, Ni, Cu, Zn, Zr, Mo, W, and Pb.

5. The single-crystal silicon pulling silica container according to any one of claims 1 to 4, wherein
a region in which the silica glass layer formed on the inner surface of the bottom portion is formed has a diameter which is 1/3 or more of an outside diameter of the silica container.

6. A method for producing a single-crystal silicon pulling silica container comprising a straight body portion, a curved portion, and a bottom portion, the method comprising:
a step of making silica powder having a particle size of 10 to 1000 µm as first raw material powder;
a step of making silica powder having a particle size of 10 to 1000 µm and containing the OH group in a concentration of more than 300 ppm by mass but 3000 ppm by mass or less as second raw material powder;
a step of obtaining a temporary compact made of the first raw material powder by charging the first raw material powder into a mold having rotational symmetry and temporarily molding the first raw material powder into a predetermined shape corresponding to an inner wall of the mold while rotating the mold;
a step of making a silica container whose outside is made of opaque silica glass containing gaseous bubbles and inside is made of transparent silica glass containing substantially no gaseous bubble, the silica container comprising a straight body portion, a curved portion, and a bottom portion, by performing heating from an inside of the temporary compact made of the first raw material powder by a discharge heating melting method while rotating the mold; and
a step of forming a silica glass layer in an inner surface portion of the bottom portion by melting the second raw material powder by the discharge heating melting method while spreading the second raw material powder into a space in the silica container thus made and making the melted second raw material powder adhere to the inner surface portion of the bottom portion.

7. The method for producing a single-crystal silicon pulling silica container according to claim 6, wherein
heating of the temporary compact made of the first raw material powder is performed concurrently with pressure reduction from an outside of the temporary compact made of the first raw material powder.

8. The method for producing a single-crystal silicon pulling silica container according to claim 6 or 7, wherein
the second raw material powder is synthetic silica glass powder.

9. The method for producing a single-crystal silicon pulling silica container according to any one of claims 6 to 8, wherein
the impurity concentrations of the second raw material powder are set at 100 ppb by mass or less for each of Li, Na, and K, at 50 ppb by mass or less for each of Ca and Mg, and at 20 ppb by mass or less for each of Ti, Cr, Fe, Ni, Cu, Zn, Zr, Mo, W, and Pb.

10. The method for producing a single-crystal silicon pulling silica container according to any one of claims 6 to 9, wherein
a region in which the silica glass layer formed on the inner surface portion of the bottom portion is formed has a diameter which is 1/3 or more of an outside diameter of the silica container.
